# EUROPEAN PATENT APPLICATION

(11) **EP 4 398 294 A1**
(43) Date of publication of application: **10.07.2024**
(21) Application number: 22864501.6
(22) Date of filing: 29.08.2022
(51) Int. Cl.: H01L 23/36, B22F 3/14, B22F 7/00, C22C 1/05, C22C 1/10, C22C 9/00, H01L 23/373

(54) **GRAPHITE-COPPER COMPOSITE MATERIAL, HEAT SINK MEMBER USING SAME, AND METHOD FOR MANUFACTURING GRAPHITE-COPPER COMPOSITE MATERIAL**

(30) Priority: 01.09.2021 JP 2021142732
(71) Applicant: UBE Corporation, Ube-shi, Yamaguchi 755-8633 (JP)
(72) Inventor: YOSHIMURA, Masafumi, Ube-shi, Yamaguchi 755-8633 (JP); INAMORI, Dai, Ube-shi, Yamaguchi 755-8633 (JP); SUNAMOTO, Kenichi, Hiroshima-shi, Hiroshima 736-0082 (JP)
(74) Representative: Michalski Hüttermann & Partner Patentanwälte mbB
(86) International application number: PCT/JP2022/032419
(87) International publication number: WO 2023/032919

(57) **Abstract**

A graphite-copper composite material includes a copper layer and scaly graphite particles stacked via the copper layer. The graphite-copper composite material has a copper volume fraction of 3% to 30%. A thickness of a copper oxide layer at an interface between the copper layer and the scaly graphite particles is 100 nm at a maximum.

## Description

### Technical Field

The present invention relates to a graphite-copper composite material, a heat sink member using the same, and a method for producing the graphite-copper composite material.

### Background Art

A material for a heat dissipation component of semiconductor equipment is required to have a high thermal conductivity. Copper has a high thermal conductivity, but also has a high thermal expansion coefficient. A metal-graphite composite material has been proposed as a composite material that reduces the thermal expansion coefficient without impairing the high thermal conductivity of copper and can be obtained at a low cost (for example, see Patent Literature 1) . It is disclosed that the metal-graphite composite material of Patent Literature 1 has a high cooling reliability and a low linear expansion coefficient.

### Citation List

### Patent Literature

Patent Literature 1: JP 2017-128802 A

### Summary of Invention

### Technical Problem

However, in recent years, with the advancement of new technologies such as the IOT, AI, and electric vehicles, a demand for heat dissipation has further increased. Specifically, a graphite-copper composite material having a high heat dissipation and a stable thermal conductivity of about 700 W/(m·K) which exceeds 600 W/(m·K) at present, and further about 850 W/(m·K) is required.

Therefore, an object of the present invention is to provide a graphite-copper composite material having a higher thermal conductivity than a conventional one, a heat sink member using the same, and a method for producing the graphite-copper composite material.

### Solution to Problem

As a result of performing examinations to solve the above-described problem, the present inventors has found that a graphite-copper composite material having a higher thermal conductivity than a conventional one can be obtained by restricting a thickness of a copper oxide layer at an interface between graphite particles and a copper layer to 100 nm or less.

That is, the present invention provides a graphite-copper composite material that includes: a copper layer; and scaly graphite particles stacked via the copper layer. The graphite-copper composite material has a copper volume fraction of 3% to 30%. A thickness of a copper oxide layer at an interface between the copper layer and the scaly graphite particles is 100 nm at a maximum.

The present invention provides a heat sink member including the graphite-copper composite material described above.

Further, the present invention provides the method for producing the graphite-copper composite material described above, the producing method including: pretreating graphite particles to obtain scaly graphite particles; mixing the scaly graphite particles with copper particles having an oxygen concentration of 0.40% or less to obtain a molding raw material; and sintering a molded body, obtained by molding the molding raw material, by a multiaxial electric current sintering method.

### Advantageous Effects of Invention

According to the present invention, a graphite-copper composite material having a higher thermal conductivity than a conventional one, a heat sink member using the same, and a method for producing the graphite-copper composite material can be provided.

### Brief Description of Drawings

FIG. 1 illustrates an example of EDS mapping of a stacked cross section of a graphite-copper composite material.
FIG. 2 is a diagram for describing an example of a method for thinning graphite particles.
FIG. 3 is a diagram for describing another example of the method for thinning the graphite particles.
FIG. 4 is a schematic diagram for describing multiaxial electric current sintering equipment.
FIG. 5 is a schematic diagram for describing a cooling substrate.

### Description of Embodiments

Embodiments of the present invention are described in detail below.

### <Graphite-Copper Composite Material>

A graphite-copper composite material (hereinafter also simply referred to as composite material) of the present invention is a sintered body obtained by using scaly graphite particles and copper particles as raw materials. The scaly graphite particles are stacked via a copper layer. Here, "with a copper layer interposed therebetween" means that the scaly graphite particles are connected by an adjacent copper layer. That is, the scaly graphite particles in the composite material are electrically continuous. While a thickness of the copper layer in the composite material is not particularly limited, it is generally about 3 µm to 25 um.

A copper volume fraction in the composite material is 3% to 30%. Since a content rate of graphite having a high thermal conductivity is as high as 70% to 97%, the thermal conductivity of the composite material of the present invention is very high. Copper acts as a binder in the composite material. In consideration of avoiding fracture of the composite material during processing, a volume ratio of graphite to copper (graphite:copper) in the composite material is preferably 70:30 to 97:3. In order to ensure a high thermal conductivity of 780 W/(m·K) or more and good processability, the volume ratio (graphite: copper) is more preferably 84:16 to 95:5. The copper volume fraction in the composite material can be adjusted by a blending ratio of the raw materials in production.

Furthermore, in the composite material of the present invention, a copper oxide layer at an interface between the copper layer and the scaly graphite particles has a thickness of 100 nm or less. Copper oxide refers to copper(II) oxide, copper (I) oxide, and the like and is generated, in some cases, at the interface between the copper layer and the scaly graphite particles due to oxygen in the copper particles used as raw materials for production. The present inventors focused on the copper oxide layer in the composite material and were able to increase the thermal conductivity by restricting the thickness of the copper oxide layer.

In order to clearly investigate the interface between the copper layer and the scaly graphite particles, a stacked cross section in the composite material was created using a cross-section polisher, and further, carbon deposition was performed on the cross section. The thickness of the copper oxide layer present at the interface can be obtained by elemental mapping using energy-dispersive X-ray spectroscopy (EDS) by observing the stacked cross section using a field emission scanning electron microscope (FE-SEM).

The stacked cross section is a cross section in which the stacked scaly graphite particles are observed, and specifically, is a surface that includes a direction in which the stacked scaly graphite particles are pressurized when molding raw materials containing the scaly graphite particles are sintered to produce the composite material. When the composite material is column-shaped, a longitudinal direction of the column corresponds to the direction in which the scaly graphite particles are stacked. Therefore, a plate material having a thickness of about 2 mm is clipped in the longitudinal direction of the column to create the stacked cross section.

A way of obtaining the thickness of the copper oxide layer is described below. First, an arbitrary region (about 3.2 um × 4.2 µm) of the stacked cross section of the composite material is defined as an observation region. The observation region is observed using an FE-SEM, and an FE-SEM image is imaged at an accelerating voltage of 3 kV and an imaging magnification of 30000 times. Cu-mapping and O-mapping are obtained by EDS in the same field of view as the FE-SEM image, and further, by overlaying these two pieces of mapping data, the copper oxide layer at the interface between the copper layer and the scaly graphite particles can be confirmed.

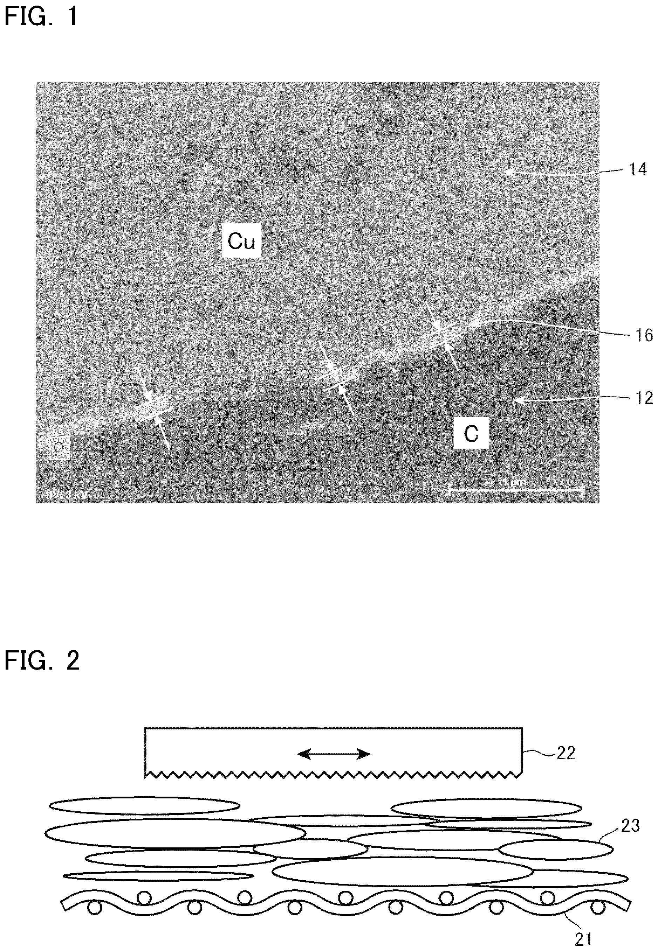

FIG. 1 illustrates an example of the obtained EDS mapping. As illustrated in FIG. 1, a copper oxide layer 16 of about 100 nm at a maximum is confirmed in a part of the interface between scaly graphite particles 12 and a copper layer 14. A thickness of the copper oxide layer 16 at the interface is confirmed by similarly observing 10 or more observation regions. In the composite material of the present invention, at the interface between a copper layer 12 and scaly graphite particles 14, there are places where the copper oxide layer 16 of about 50 nm to 90 nm is confirmed, but any copper oxide layer exceeding 100 nm is not confirmed. The thickness of the copper oxide layer 16 is preferably 90 nm or less and more preferably 50 nm or less .

The composite material of the present invention preferably has a thermal conductivity of 850 W/(m·K) or more. The thermal conductivity is a value measured in a direction perpendicular to a direction in which the scaly graphite particles are stacked. In order to be used for high-output electronic parts and the like, the thermal conductivity is more preferably 880 W/(m·K) or more. For the thermal conductivity, a sample having predetermined dimensions (outer diameter 10 mm × thickness 2.5 mm) are clipped from a center portion of the composite material and measured using a LFA447 manufactured by Netzsch Group in accordance with the laser flash method (Japanese Industrial Standard H 7801:2005). An average of the thermal conductivities of five samples clipped from the composite material is used.

### <Producing Method>

The composite material of the present invention can be produced by performing a pretreatment on graphite particles to obtain scaly graphite particles, mixing the scaly graphite particles with predetermined copper particles to obtain a molding raw material, molding the molding raw material, and sintering the molding raw material under predetermined conditions. Each step is described below.

### (Graphite Pretreatment)

The pretreatment (hereinafter referred to as thinning in some cases) of the graphite particles is performed by applying a shear force to the graphite particles to reduce the thickness. The graphite particles to be used are not particularly limited, but generally have a long side of about 2,000 um to 10 um and a thickness of about 200 um to 20 um. Examples of the graphite that can be used include +3299 (manufactured by Ito Graphite Co., Ltd.) and the like.

In the pretreatment, for example, as illustrated in FIG. 2, a sieve 21 on which graphite particles 23 are placed and a grindstone 22 that is in contact with the graphite particles 23 and can reciprocate in a horizontal direction can be used. A length of the long side of the obtained scaly graphite particles can be selected according to a mesh size of the sieve 21 to be used. The mesh size of the sieve 21 can be, for example, about 53 um. As the grindstone 22, a rough grindstone to a medium grindstone are preferred, and one using alundum or natural diamond as abrasive grains is preferred. The graphite particles 23 are disposed on the sieve 21, and the grindstone 22 is reciprocated in the horizontal direction to apply the shear force, thereby reducing the thickness of the graphite particles 23.

The graphite particles 23 having voids generated inside due to the shear force or those that are fragile and are easily collapsed are removed by the sieve 21. As a result, in the obtained scaly graphite particles, the thickness is reduced, and the density is increased. Furthermore, impurities in the graphite particles are removed, leading to the improvement in purity. Note that the scaly graphite particles of various sizes can be obtained by changing a size of the abrasive grains used for the treatment and the mesh size of the sieve.

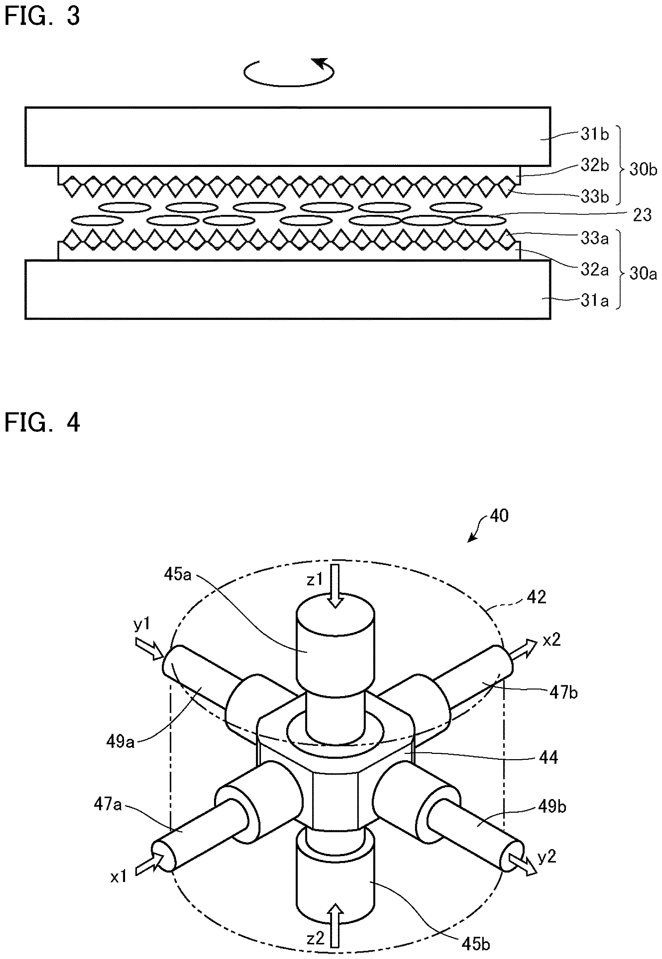

As illustrated in FIG. 3, two grindstones 30a and 30b can also be used for the pretreatment of the graphite particles. The grindstone 30b is a rotatable rotary grindstone. The grindstones 30a and 30b have metal plates 31a and 31b respectively, and abrasive grains 33a and 33b, such as diamond, are provided on opposed surfaces. The abrasive grains 33a and 33b are fixed by joining metal members 32a and 32b, such as plating, and the graphite particles 23 to be treated are disposed between the abrasive grains 33a and 33b. When the pretreatment is performed on the graphite particles 23 using the grindstones 30a and 30b, relatively small and thin scaly graphite particles can be efficiently obtained.

By the pretreatment as described above, the scaly graphite particles having a reduced thickness are obtained. The scaly graphite particles have a structure in which a plurality of graphite pieces overlap. As the thickness of the scaly graphite particles is smaller, a gap between the graphite pieces in the graphite particles is reduced, and the thermal conductivity and mechanical characteristics are improved. The thickness of the scaly graphite particles can be adjusted by the type of the graphite particles to be used, the pretreatment conditions, and the like.

In order to obtain a composite material having a higher thermal conductivity and better processability, the thickness of the scaly graphite particles is preferably 30 um or less. By performing the pretreatment in this way, a shape of the scaly graphite particles is fixed. For example, when the sieve 21 having a mesh size of 53 um is used, the scaly graphite particles having a long side of 60 um or more are obtained.

### (Preparation of Copper Particles)

As the copper particles, copper particles having an oxygen concentration of 0.40% or less are used. The oxygen concentration of copper particles conventionally used in the production of composite materials was about 0.42%. The oxygen concentration in the copper particles can be confirmed by a high-frequency combustion-infrared absorption method. As the oxygen concentration is lower, thermal conductivity of the composite material improves. Therefore, the oxygen concentration in the copper particles is more preferably 0.35% or less and further preferably 0.25% or less.

As long as the oxygen concentration of the copper particles is 0.40% or less, other conditions are not particularly limited. For example, a volume-based median diameter of the copper particles can be about 1.5 um or less. When small copper particles having a median diameter of 1.5 um or less are used, a composite material having a stable thermal conductivity and processability can be obtained. The copper particles having a median diameter of 1.5 um or less can be produced by any method. For example, copper particles having a desired grain diameter are obtained by a chemical reduction method or a physical production method.

### (Mixing)

The scaly graphite particles obtained by performing the pretreatment and predetermined copper particles are blended in a predetermined ratio and mixed to obtain a molding raw material. In the mixing, any of dry mixing and wet mixing may be performed. The blending ratio of the raw materials is selected such that the volume ratio of graphite to copper (graphite:copper) in the composite material is 70:30 to 97:3. From the viewpoint of thermal conductivity and processability, the volume ratio (graphite:copper) is preferably selected so as to be 84:16 to 95:5.

### (Sintering)

First, a small amount (about 40 g or less) of the molding raw material is filled in a predetermined molding die, and compacted at a pressure of about 3 MPa to 15 MPa using, for example, a hydraulic hand press. As the molding die, for example, an SUS mold having a diameter of 30 mm can be used. The filling and compacting of the molding raw material are repeated to produce a molded body having a desired size. The obtained molded body is sintered by a multiaxial electric current sintering method to obtain a sintered body to be the composite material of the present invention.

Here, with reference to FIG. 4, an outline of multiaxial electric current sintering equipment is described. In multiaxial electric current sintering equipment 40 illustrated in FIG. 4, a carbon mold 44 in which the molded body is housed can be fixed in a vacuum chamber 42 by vertical pressurizing shafts 45a and 45b and horizontal heating shafts (A) 47a and 47b and horizontal heating shafts (B) 49a and 49b. The heating shafts (A) 47a and 47b and the heating shafts (B) 49a and 49b are configured such that they can be alternately energized. The heating shafts (A) are energized in directions of arrows x1 and x2, and the heating shafts (B) are energized in directions of arrows y1 and y2.

In the multiaxial electric current sintering equipment 40, the pressurizing shafts 45a and 45b and the heating shafts 47a, 47b, 49a, and 49b are separated from one another. Specifically, the pressurizing shafts 45a and 45b are in a z-axis direction, the heating shafts (A) 47a and 47b are in an x-axis direction, and the heating shafts (B) 49a and 49b are in a y-axis direction. This makes independent control of pressurizing and heating possible, and therefore, a uniform temperature distribution can be obtained in a radial direction of the molded body.

In the sintering, after the carbon mold 44 in which the molded body is housed is fixed in the vacuum chamber 42, the pressure in the vacuum chamber 42 is reduced to 100 Pa or less, preferably 50 Pa or less in order to restrain oxidative deterioration of components in the equipment. Next, the heating shafts (A) 47a and 47b are energized, and heating is performed to about 650°C to 750°C, preferably about 670°C to 730°C, while pressurizing is performed up to 10 MPa in a direction of arrow z1 and a direction of arrow z2 by the vertical pressurizing shafts 45a and 45b.

Thereafter, switching to the heating shafts (B) 49a and 49b is performed, and heating is performed to about 930°C to 980°C, preferably about 940°C to 970°C, while pressurizing is performed up to 30 MPa to 100 MPa in the direction of arrow z1 and the direction of arrow z2 by the vertical pressurizing shafts 45a and 45b. The pressure at this time is preferably about 30 MPa to 100 MPa, and more preferably about 40 MPa to 70 MPa.

Conditions for pressurizing and temperature rising during sintering are not limited to those described above and can be set appropriately. For example, after pressurizing is performed up to 10 MPa in the direction of arrow z1 and the direction of arrow z2 by the vertical pressurizing shafts 45a and 45b, the heating shafts (A) 47a and 47b are energized, and heating is performed to about 650°C to 750°C, preferably about 670°C to 730°C. Thereafter, switching to the heating shafts (B) 49a and 49b is performed, and heating is performed to about 930°C to 980°C, preferably about 940°C to 970°C, while pressurizing is performed up to 30 MPa to 100 MPa in the direction of arrow z1 and the direction of arrow z2 by the vertical pressurizing shafts 45a and 45b. The pressure at this time is preferably about 30 MPa to 100 MPa, and more preferably about 40 MPa to 70 MPa.

Alternatively, the heating shafts (A) 47a and 47b are energized, and heating is performed to about 650°C to 750°C, preferably about 670°C to 730°C. Thereafter, switching to the heating shafts (B) 49a and 49b is performed, and heating is performed to about 930°C to 980°C, preferably about 940°C to 970°C, while pressurizing is performed up to 30 MPa to 100 MPa in the direction of arrow z1 and the direction of arrow z2 by the vertical pressurizing shafts 45a and 45b. The pressure at this time is preferably about 30 MPa to 100 MPa, and more preferably about 40 MPa to 70 MPa.

Even when any conditions are used to perform pressurizing and temperature rising, the multiaxial electric current method sinters it with a uniform temperature distribution. Therefore, a composite material with stable quality can be produced. Moreover, since copper particles having an oxygen concentration of 0.40% or less are used together with the scaly graphite particles as the raw materials, in the composite material of the present invention, the copper oxide layer at the interface between the copper layer and the scaly graphite particles has a thickness of 100 nm or less. The thickness of the copper oxide layer being 100 nm or less allowed the composite material of the present invention to increase the thermal conductivity without impairing any of the conventional properties.

The composite material of the present invention can be suitably used as a heat sink (a heat sink member). The heat sink member is used in a wide range of fields, such as a wireless communication field, an electronic control field, and an optical communication field. Specific examples of the application include a power semiconductor module, an optical communication module, a projector, a Peltier cooler, a water-cooled cooler, an LED heat dissipation fan, and the like.

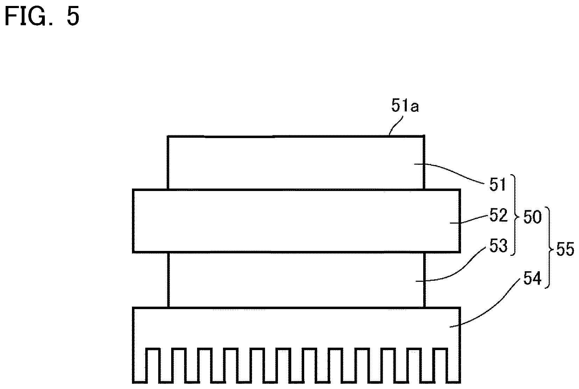

FIG. 5 illustrates an example of a cooling substrate using the heat sink. A cooling substrate 55 includes a heat sink 50 and a cooling layer 54. The heat sink 50 has an electrical insulating layer 52 and a wiring layer 51 sequentially stacked on a stress buffer layer 53. A heat-generating element, such as a semiconductor element, is mounted on a mounting surface 51a on an upper surface of the wiring layer 51. The composite material of the present invention can be used for at least one layer of the stress buffer layer 53 and the wiring layer 51.

Heat generated in the heat-generating element mounted on the mounting surface 51a of the heat sink 50 is sequentially conducted to the wiring layer 51, the electrical insulating layer 52, the stress buffer layer 53, and the cooling layer 54, and is dissipated from the cooling layer 54. Since the composite material of the present invention has a higher thermal conductivity than a conventional one, the heat-generating element can be cooled more efficiently than the conventional one, and the temperature thereof can be lowered.

### Examples

Next, the present invention is specifically described with examples. However, the present invention is not limited to the examples below.

### (Example 1)

A pretreatment was performed on commercially available raw material graphite by the method described with reference to FIG. 3. Upper and lower grindstones were equipped with diamonds as abrasive grains, and between the upper and lower grindstones, 5 g of graphite particles were inserted together with 2 mL of water. The pretreatment for about 20 seconds was performed on the graphite particles by rotating the rotary grindstone at 10 Hz. The pressure at that time was set to be 0.5 MPa.

The graphite particles after the treatment were classified using a sieve having a mesh size of 500 um, and the graphite particles that remained on an upper surface of the sieve were taken out and dried. These graphite particles were taken as scaly graphite particles of raw materials. Meanwhile, as copper particles, commercially available copper particles having an oxygen concentration of 0.22% were prepared.

By blending 11.0 g of the scaly graphite particles after performing the pretreatment and drying and 19.0 g of the copper particles such that a copper volume fraction after sintering was 30%, a molding raw material was obtained. These powders were housed in a 250 mL plastic bottle and mixed by a ball mill.

In an SUS mold having a diameter of 30 mm, 3 g of the molding raw material was put and compacted at a pressure of 5 MPa using a hydraulic press. Molding was performed in which operations of inputting and compacting the molding raw material were repeated about more than 10 times, and a molded body was taken out from the SUS mold.

The molded body taken out was housed in a cylindrically-shaped carbon mold and sintered by the multiaxial electric current sintering method. The carbon mold 44 was disposed in the vacuum chamber 42 of the multiaxial electric current sintering equipment 40 illustrated in FIG. 4, and fixed with the two heating shafts (A) 47a and 47b on a diagonal line and the two pressurizing shafts (B) 45a and 45b.

The pressure in the vacuum chamber 42 was reduced to 5 Pa by a rotary pump, and the temperature was raised by increasing an output of an equipment power supply while pressurizing was performed up to 10 MPa in the direction of arrow z1 and the direction of arrow z2 by the vertical pressurizing shafts 45a and 45b. After heating was performed up to 700°C with the heating shafts (A) 47a and 47b by raising the temperature, changing to the heating shafts (B) 49a and 49b was performed to heat up to 950°C while pressurizing was performed up to 50 MPa in the direction of arrow z1 and the direction of arrow z2 by the vertical pressurizing shafts 45a and 45b.

After the temperature reached 950°C, it was held for 30 seconds, and the output of the power supply was lowered to cool the equipment. After the cooling, the carbon mold 44 was taken out from the equipment, and a column-shaped sintered body was obtained from an inside of the mold.

The same operation was performed five times to produce five sintered bodies, and a composite material of Example 1 was obtained.

### (Example 2)

A composite material of Example 2 was produced similarly to Example 1 except that the molding raw material was changed such that the copper volume fraction after the sintering was 16%.

### (Example 3)

A composite material of Example 3 was produced similarly to Example 1 except that the molding raw material was changed such that the copper volume fraction after the sintering was 5%.

### (Comparative Example 1)

A composite material of Comparative Example 1 was produced similarly to Example 1 except that copper particles having an oxygen concentration of 0.42% were used. The copper particles used here correspond to those conventionally used in the production of composite materials.

### (Comparative Example 2)

A composite material of Comparative Example 2 was produced similarly to Example 2 except that copper particles having an oxygen concentration of 0.42% were used.

### (Comparative Example 3)

A composite material of Comparative Example 3 was produced similarly to Example 3 except that copper particles having an oxygen concentration of 0.42% were used.

For the composite materials of the examples and the comparative examples, the thickness of the copper oxide layer at the interface between the copper layer and the scaly graphite particles was obtained, and the thermal conductivity was evaluated. In each case, five composite materials were measured, and an average was taken.

### <Thickness of Copper Oxide Layer>

As described above, the thickness of the copper oxide layer at the interface between the copper layer and the scaly graphite particles in the composite material was obtained.

### <Thermal Conductivity>

When samples for thermal conductivity measurement were produced, first, plates were clipped in the longitudinal direction from the center of the columns of the composite materials of the examples and the comparative examples. The longitudinal direction of the columns is a direction in which the scaly graphite particles are stacked. By processing the plates, the samples for thermal conductivity measurement having an outer diameter of 10 mm and a thickness of 2.5 mm were obtained. A thickness direction of the samples is a direction perpendicular to the direction in which the scaly graphite particles are stacked (pressurizing direction). In this thickness direction, the thermal conductivity of the sample was measured in accordance with the "Method for measuring thermal diffusivity of metals by the laser flash method" (Japanese Industrial Standard H 7801:2005).

The obtained results are summarized in Table 1 below, along with the copper volume fraction and the oxygen concentration in the copper particles as raw materials.

**[Table 1]**

| | Copper volume fraction (%) | Oxygen concentration in copper particles (%) | Thickness of copper oxide layer (nm) | Thermal conductivity (W/m·K) |
|---|---|---|---|---|
| Example 1 | 30 | 0.22 | 62 | 780 |
| Example 2 | 16 | | 85 | 888 |
| Example 3 | 5 | | 40 | 892 |
| Comparative Example 1 | 30 | 0.42 | 148 | 750 |
| Comparative Example 2 | 16 | | 141 | 810 |
| Comparative Example 3 | 5 | | 133 | 820 |

As illustrated in the above Table 1, in the composite materials produced using the copper particles having an oxygen concentration of 0.22%, the thickness of the copper oxide layer at the interface between the copper layer and the scaly graphite particles is 85 nm or less (Examples 1 to 3) . It is shown that the thickness of the copper oxide layer can be controlled to be 100 nm or less by controlling the oxygen concentration in the copper particles to be 0.40% or less. The composite materials of these examples have a thermal conductivity of 780 W/(m·k) or more, which is higher than that of the conventional one.

In contrast to this, in the composite materials using the copper particles having an oxygen concentration of 0.42% (Comparative Examples 1 to 3), the thickness of the copper oxide layer at the interface between the copper layer and the scaly graphite particles exceeds 100 nm and reaches 148 nm at a maximum. As compared with the composite materials of the examples containing copper in the same volume fraction, it can be seen that in any volume fraction case, the composite materials of the comparative examples are inferior in thermal conductivity.

Since 70% or more of the volume of a composite material is graphite, the thermal conductivity of the composite material is considered to depend on the thermal conductivity of the graphite. Although it is unlikely that the oxygen concentration in the copper layer affects the thermal conductivity, it is presumed that the interface between the copper layer and the scaly graphite particles greatly affects a thermal resistance of the composite material.

From the above results, it was confirmed that a lead-copper composite material having a lowered thermal resistance and a higher thermal conductivity than a conventional one could be obtained by reducing not the amount of oxygen in the entire copper layer in the composite material but the thickness of the copper oxide layer at the interface between the copper layer and the scaly graphite particles.

### Reference Signs List

- 12: Graphite particle
- 14: Copper layer
- 16: Copper oxide layer
- 21: Sieve
- 22: Grindstone
- 23: Graphite particles
- 30a, 30b: Grindstone
- 31a, 31b: Metal plate
- 32a, 32b: Joining metal member
- 33a, 33b: Abrasive grains
- 40: Multiaxial electric current sintering equipment
- 42: Vacuum chamber
- 44: Carbon mold
- 45a, 45b: Pressurizing shaft
- 47a, 47b: Heating shaft
- 49a, 49b: Heating shaft
- 50: Heat sink
- 51: Wiring layer
- 52: Electrical insulating layer
- 53: Stress buffer layer
- 54: Cooling layer
- 55: Cooling substrate

## Claims

1. A graphite-copper composite material comprising:
a copper layer; and
scaly graphite particles stacked via the copper layer, wherein
the graphite-copper composite material has a copper volume fraction of 3% to 30%, and
a thickness of a copper oxide layer at an interface between the copper layer and the scaly graphite particles is 100 nm at a maximum.

2. The graphite-copper composite material according to claim 1, wherein
a thermal conductivity in a direction perpendicular to a direction in which the scaly graphite particles are stacked is 850 W/(m·K) or more.

3. A heat sink member comprising the graphite-copper composite material according to claim 1 or 2.

4. A method for producing the graphite-copper composite material according to claim 1, the producing method comprising:
pretreating graphite particles to obtain scaly graphite particles;
mixing the scaly graphite particles with copper particles having an oxygen concentration of 0.40% or less to obtain a molding raw material; and
sintering a molded body, obtained by molding the molding raw material, by a multiaxial electric current sintering method.
